# EUROPEAN PATENT APPLICATION

(11) **EP 4 603 855 A1**
(43) Date of publication of application: **20.08.2025**
(21) Application number: 23888957.0
(22) Date of filing: 16.10.2023
(51) Int. Cl.: G01R 31/392, G01R 31/396, G01R 31/3842, G01R 19/00, G01R 19/10, G01R 19/30, G01R 31/371

(54) **BATTERY DIAGNOSIS APPARATUS AND OPERATION METHOD THEREOF**

(30) Priority: 11.11.2022 KR 20220151070
(71) Applicant: LG Energy Solution, Ltd., Seoul 07335 (KR)
(72) Inventor: KIM, Won Kyung, Daejeon 34122 (KR); LEE, Jeong Bin, Daejeon 34122 (KR); KIM, In Sik, Daejeon 34122 (KR); YOON, Sung Yul, Daejeon 34122 (KR); KIM, Soon Jong, Daejeon 34122 (KR); KWON, Ki Wook, Daejeon 34122 (KR); SONG, Young Seok, Daejeon 34122 (KR)
(74) Representative: Plasseraud IP
(86) International application number: PCT/KR2023/015923
(87) International publication number: WO 2024/101694

(57) **Abstract**

A battery diagnosis apparatus according to an embodiment disclosed herein includes an obtaining unit configured to obtain first voltage values of each of a plurality of battery units, an identifying unit configured to identify second voltage values in different idle periods from among the first voltage values, a determining unit configured to determine average voltage values of the different idle periods of each of the plurality of battery units, based on the second voltage values, and a diagnosing unit configured to diagnose an abnormality of each of the plurality of battery units, based on at least one deviation value among the average voltage values.

## Description

### [TECHNICAL FIELD]

### CROSS-REFERENCE TO RELATED APPLICATION

This application claims priority to and the benefit of Korean Patent Application No. 10-2022-0151070 filed in the Korean Intellectual Property Office on November 11, 2022, the entire content of which is incorporated herein by reference.

### TECHNICAL FIELD

Embodiments disclosed herein relate to a battery diagnosis apparatus and an operating method thereof.

### [BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Furthermore, the secondary battery may be used as a battery pack including a battery module where a plurality of battery cells are connected to one another in series and/or in parallel. The secondary battery may be used as a battery rack including a plurality of battery modules and a rack frame receiving the battery modules.

The battery cell, the battery module, the battery pack, or the battery rack may be used in various devices. For example, the batteries may be used not only for mobile devices such as mobile phones, laptop computers, smart phones, smart pads, etc., but also in the field of vehicles (EV, HEV, PHEV) driven with electricity, large-volume energy storage systems (ESS), etc.

These batteries may be managed and controlled in terms of states and operations thereof by a battery management system (BMS). The battery management system may be included together with a battery in one device. The battery management system may also manage and control the battery in a state of being spaced apart from a device including the battery.

### [DISCLOSURE]

### [TECHNICAL PROBLEM]

When a short circuit or a failure of another type occurs inside a battery, the possibility of damage to devices (e.g., EV, ESS) including the battery may increase.

Accordingly, there is a need for a scheme to reduce the possibility of damage to devices including a battery by detecting an abnormal state of the battery.

Technical problems of the embodiments disclosed herein are not limited to the above-described technical problems, and other unmentioned technical problems would be clearly understood by one of ordinary skill in the art from the following description.

### [TECHNICAL SOLUTION]

A battery diagnosis apparatus according to an embodiment disclosed herein includes an obtaining unit configured to obtain first voltage values of each of a plurality of battery units, an identifying unit configured to identify second voltage values in different idle periods from among the first voltage values, a determining unit configured to determine average voltage values of the different idle periods of each of the plurality of battery units, based on the second voltage values, and a diagnosing unit configured to diagnose an abnormality of each of the plurality of battery units, based on at least one deviation value among the average voltage values.

In the battery diagnosis apparatus according to an embodiment disclosed herein, the diagnosing unit may be further configured to calculate, for each of the plurality of battery units, a first deviation value that is a result of subtracting, from a second average voltage value of a second idle period after a first idle period, a first average voltage value of the first idle period, among the average voltage values and diagnose an abnormality of each of the plurality of battery units, based on the first deviation value.

In an embodiment, the diagnosing unit may be further configured to diagnose an abnormality of each of the plurality of battery units, based on at least one of a maximum value, a minimum value, or an average value of the at least one deviation value.

In the battery diagnosis apparatus according to an embodiment disclosed herein, the diagnosing unit may be further configured to diagnose at least one battery unit having the maximum value greater than a first reference value, as an abnormal battery unit.

In the battery diagnosis apparatus according to an embodiment disclosed herein, the diagnosing unit may be further configured to diagnose at least one battery unit having the minimum value greater than a second reference value, as an abnormal battery unit.

In the battery diagnosis apparatus according to an embodiment disclosed herein, the diagnosing unit may be further configured to diagnose at least one battery unit having the average value greater than a third reference value, as an abnormal battery unit.

In the battery diagnosis apparatus according to an embodiment disclosed herein, the identifying unit may be further configured to set the different idle periods as periods having voltage values, current values, the amounts of charge, and/or the amounts of discharge in designated ranges.

The battery diagnosis apparatus according to an embodiment disclosed herein may further include an abnormality processing unit configured to perform an abnormality processing function based on an abnormality diagnosis result of each of the plurality of battery units, in which the abnormality processing function includes a notification function or a shortcircuit function.

A battery diagnosis method according to an embodiment disclosed herein includes obtaining first voltage values of each of a plurality of battery units, identifying second voltage values in different idle periods from among the first voltage values, determining average voltage values of the different idle periods of each of the plurality of battery units, based on the second voltage values, and diagnosing an abnormality of each of the plurality of battery units, based on at least one deviation value among the average voltage values.

In the battery diagnosis method according to an embodiment disclosed herein, the diagnosing of the abnormality of each of the plurality of battery units may include calculating, for each of the plurality of battery units, a first deviation value that is a result of subtracting, from a second average voltage value of a second idle period after a first idle period, a first average voltage value of the first idle period, among the average voltage values, and diagnosing an abnormality of each of the plurality of battery units, based on the first deviation value.

In the battery diagnosis method according to an embodiment disclosed herein, the diagnosing of the abnormality of each of the plurality of battery units may include diagnosing the abnormality of each of the plurality of battery units, based on at least one of a maximum value, a minimum value, or an average value of the at least one deviation value.

In the battery diagnosis method according to an embodiment disclosed herein, the diagnosing of the abnormality of each of the plurality of battery units may include diagnosing at least one battery unit having the maximum value greater than a first reference value, as an abnormal battery unit.

In the battery diagnosis method according to an embodiment disclosed herein, the diagnosing of the abnormality of each of the plurality of battery units may include diagnosing at least one battery unit having the minimum value greater than a second reference value, as an abnormal battery unit.

In the battery diagnosis method according to an embodiment disclosed herein, the diagnosing of the abnormality of each of the plurality of battery units may include diagnosing at least one battery unit having the average value greater than a third reference value, as an abnormal battery unit.

The battery diagnosis method according to an embodiment disclosed herein may further include setting the different idle periods as periods having voltage values, current values, the amounts of charge, and/or the amounts of discharge in designated ranges.

### [ADVANTAGEOUS EFFECTS]

A battery diagnosis apparatus and an operating method thereof according to various embodiments disclosed herein may detect occurrence of a short circuit or a failure of another type inside a battery.

A battery diagnosis apparatus and an operating method thereof according to various embodiments disclosed herein may process the detected short circuit or failure of another type inside the battery.

The effects of the battery abnormality diagnosis apparatus and the operating method thereof according to the disclosure of the present document are not limited to the effects mentioned above, and other effects not mentioned will be clearly understood by those of ordinary skill in the art according to the disclosure of the present document.

Moreover, various effects recognized directly or indirectly from the disclosure may be provided.

### [DESCRIPTION OF DRAWINGS]

FIG. 1 shows graphs of a difference between a voltage change degree of a normal battery unit and a voltage change degree of an abnormal battery unit in idle periods.
FIG. 2 is a block diagram of a battery diagnosis apparatus according to an embodiment.
FIG. 3A is a graph showing an example where an idle period is set after charging of a battery unit, according to an embodiment.
FIG. 3B is a graph showing an example where an idle period is set after discharging of a battery unit, according to an embodiment.
FIG. 4 is an operating flowchart of a battery diagnosis apparatus according to an embodiment.
FIG. 5 is an operating flowchart of a battery diagnosis apparatus according to an embodiment.

### [Mode for Invention]

Hereinafter, various embodiments of the present disclosure will be disclosed with reference to the accompanying drawings. However, the description is not intended to limit the present disclosure to particular embodiments, and it should be construed as including various modifications, equivalents, and/or alternatives according to the embodiments of the present disclosure.

It should be appreciated that various embodiments of the present document and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1^{st}", "2^{nd}," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly), wirelessly, or via a third element.

According to an embodiment of the disclosure, a method according to various embodiments of the disclosure disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

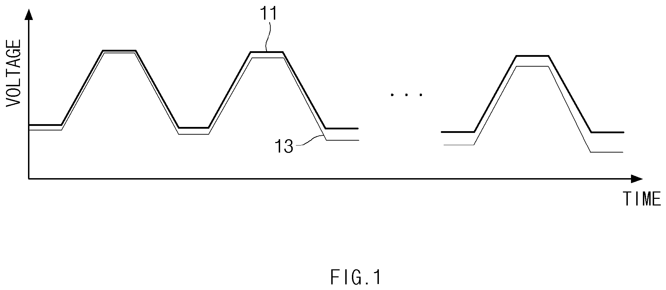

FIG. 1 shows graphs of a difference between a voltage change degree of a normal battery unit and a voltage change degree of an abnormal battery unit in idle periods.

Referring to FIG. 1, a graph 10 showing a voltage 11 of a normal battery unit and a voltage 13 of an abnormal battery unit may be seen. It may be seen from the graph 10 that for the voltage 11 of the normal battery unit, a voltage value difference is relatively small in each of idle periods in which a voltage value is maintained constant (e.g., idle periods after charging or discharging). On the other hand, it may be seen from the graph 10 that for the voltage 13 of the abnormal battery unit, a voltage value difference is relatively large in each of the idle periods. For example, for the voltage 13 of the abnormal battery unit, the voltage value may drop significantly as the idle periods continue. When a short circuit or a failure of another type occurs inside a battery unit, an abnormal behavior like the voltage 13 of the abnormal battery unit may appear.

As such, damage to an electronic device may occur due to the battery unit showing the abnormal behavior like the voltage 13 of the abnormal battery unit. Thus, a battery unit having an abnormal behavior may be detected from among battery units, and may need to be appropriately processed.

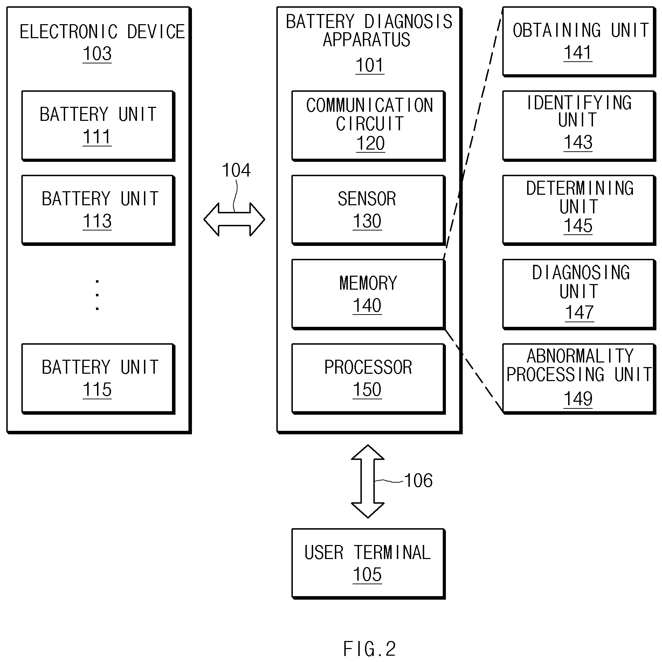

FIG. 2 is a block diagram of a battery diagnosis apparatus according to an embodiment.

Referring to FIG. 2, the battery diagnosis apparatus 101 may be wiredly and/or wirelessly connected to an electronic device 103 and a user terminal 105.

In an embodiment, connection 104 between the battery diagnosis apparatus 101 and the electronic device 103 may be communication connection through a wired and/or wireless network. In an embodiment, the wired network may be based on a local area network (LAN) communication or a power-line communication. In an embodiment, the wireless network may be based on a short-range communication network (e.g., Bluetooth, Wireless Fidelity (WiFi), or Infrared Data Association (IrDA)) or a remote-range communication network (e.g., a cellular network, a 4^{th}-Generation (4G) network, a 5^{th}-Generation (5G) network).

In another embodiment, the connection 104 between the battery diagnosis apparatus 101 and the electronic device 103 may be connection using a device-to-device communication scheme (e.g., a bus, a general-purpose input and output (GPIO), a serial peripheral interface (SPI), or a mobile industry processor interface (MIPI)).

In an embodiment, connection 106 between the battery diagnosis apparatus 101 and the user terminal 105 may be communication connection through a wired and/or wireless network.

In an embodiment, the electronic device 103 may be a mobile device (e.g., a mobile phone, a laptop computer, a smart phone, a smart pad), en electric vehicle (e.g., an electric vehicle (EV), a hybrid EV (HEV), a plug-in HEV (PHEV), a fuel cell EV (FCEV)), an energy storage system (ESS), or a battery swapping system (BSS).

In an embodiment, the electronic device 103 may include one or more battery units 111, 113, and 115. Each of the one or more battery units 111, 113, and 115 may be a battery cell, a battery module, a battery pack, or a battery rack.

In an embodiment, the user terminal 105 may be a mobile device (e.g., a mobile phone, a laptop computer, a smart phone, a smart pad), or a personal computer (PC).

In an embodiment, the battery diagnosis apparatus 101 may include a communication circuit 120, a sensor 130, a memory 140, and a processor 150. According to an embodiment, the battery diagnosis apparatus 101 shown in FIG. 2 may further include at least one component (e.g., a display, an input device, or an output device) in addition to components shown in FIG. 2.

In an embodiment, the communication circuit 120 may establish a wired communication channel and/or a wireless communication channel between the battery diagnosis apparatus 101 and the electronic device 103 and/or the user terminal 105, and transmit and receive data to and from the electronic device 103 and/or the user terminal 105 through the established communication channel.

In an embodiment, the sensor 130 may obtain values related to states of the battery units 111, 113, and 115 of the electronic device 103. In an embodiment, the values related to the states may indicate one or more values of voltages, currents, resistances, states of charge (SoC), states of health (SoH), or temperatures of the battery units 111, 113, and 115 or combinations thereof. Hereinbelow, the value related to the state may be referred to as a 'state value'.

In an embodiment, the memory 140 may include a volatile and/or a nonvolatile memory.

In an embodiment, the memory 140 may store data used by at least one component (e.g., the processor 150) of the battery diagnosis apparatus 101. For example, the data may include software (or an instruction related thereto), input data, or output data. In an embodiment, the instruction, when executed by the processor 150, may cause the battery abnormality diagnosis apparatus 101 to perform operations defined by the instruction.

In an embodiment, the memory 140 may include one or more software (e.g., an obtaining unit 141, an identifying unit 143, a determining unit 145, a diagnosing unit 147, and an abnormality processing unit 149).

In an embodiment, the processor 150 may include a central processing unit, an application processor, a graphic processing unit, a neural processing unit (NPU), an image signal processor, a sensor hub processor, or a communication processor.

In an embodiment, the processor 150 may execute software (e.g., the obtaining unit 141, the identifying unit 143, the determining unit 145, the diagnosing unit 147, and the abnormality processing unit 149) to control at least one other component (e.g., a hardware or software component) of the battery diagnosis apparatus 101 connected to the processor 150 and perform various data processing or operations.

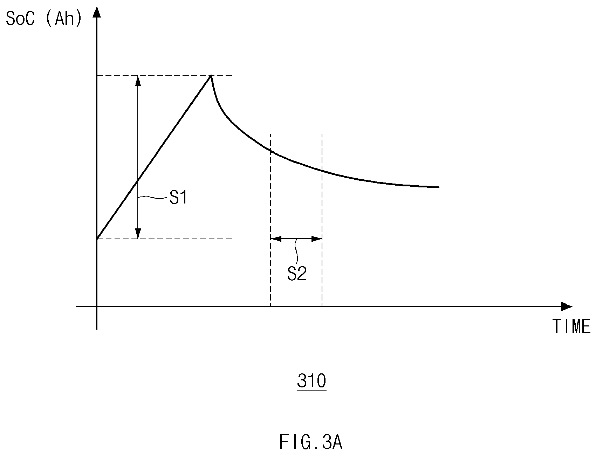

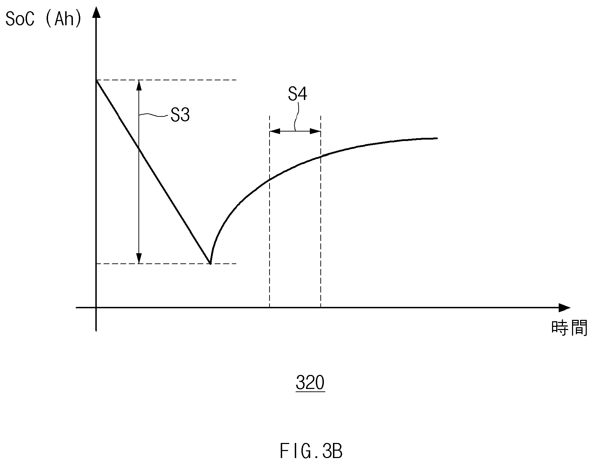

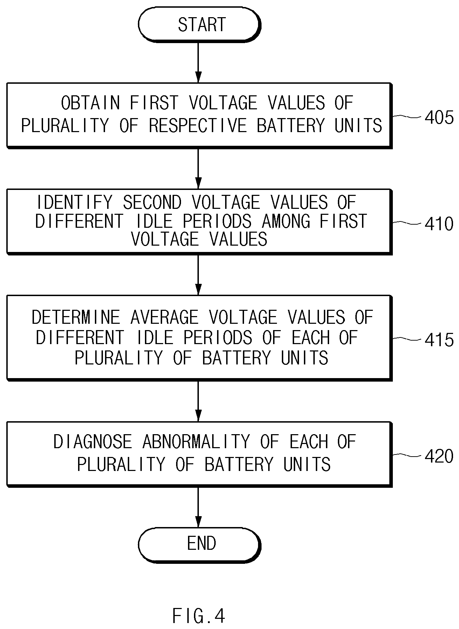

Hereinbelow, referring to FIGS. 3A, 3B, and 4, a description will be made of a method, performed by the battery diagnosis apparatus 101, of diagnosing abnormality of the battery units 111, 113, and 115 through the obtaining unit 141, the identifying unit 143, the determining unit 145, the diagnosing unit 147, and/or the abnormality processing unit 149.

FIG. 3A is a graph showing an example where an idle period is set after charging of a battery unit, according to an embodiment. FIG. 3B is a graph showing an example where an idle period is set after discharging of a battery unit, according to an embodiment. FIGS. 3A and 3B will be described using the components of FIG. 2.

In an embodiment, the obtaining unit 141 may obtain first voltage values of each of the plurality of battery units 111, 113, and 115. In an embodiment, the obtaining unit 141 may obtain a plurality of voltage profiles respectively indicating voltage changes of the plurality of battery units 111, 113, and 115 over time. The obtaining unit 141 may obtain the first voltage values based on the obtained plurality of voltage profiles.

In an embodiment, the obtaining unit 141 may obtain the first voltage values of each of the plurality of battery unit 111, 113, and 115 through the electronic device 103 connected through a wired and/or wireless network.

In an embodiment, the identifying unit 143 may identify second voltage values in different idle periods from among the first voltage values. In an embodiment, the identifying unit 143 may set the different idle periods as periods having voltage values, current values, the amounts of charge, and/or the amounts of discharge in designated ranges. The identifying unit 143 may extract the different idle periods for each of the plurality of battery units 111, 113, and 115 from the obtained plurality of voltage profiles, and identify the second voltage values in the corresponding periods for each of the plurality of battery units 111, 113, and 115.

In an embodiment, the different idle periods may be idle periods after different charging or idle periods after different discharging.

For example, referring to FIG. 3A, a charging period S1 and an idle period S2 after charging may be seen from the graph 310. In an embodiment, the identifying unit 143 may identify the charging period S1 having a designated amount of charging from the plurality of SOC profiles of the plurality of battery units 111, 113, and 115. To this end, the obtaining unit 141 may obtain the plurality of SOC profiles of the plurality of battery unit 111, 113, and 115 through the electronic device 103 connected through a wired and/or wireless network. In an embodiment, the identifying unit 143 may extract the idle period S2 after charging, based on a voltage value and/or a current value of each of the plurality of battery units 111, 113, and 115 after the charging period S1. For example, the identifying unit 143 may extract, as the idle period S2 after charging, a period in which the current value of the battery unit 111, 113, or 115 is in a first current range (e.g., a range of 0 A to 1 A).

In another example, referring to FIG. 3B, a discharging period S3 and an idle period S4 after discharging may be seen from a graph 320. In an embodiment, the identifying unit 143 may identify the discharging period S3 having a designated amount of discharging from the plurality of SOC profiles of the plurality of respective battery units 111, 113, and 115. In an embodiment, the identifying unit 143 may extract the idle period S4 after discharging, based on a voltage value and/or a current value of each of the plurality of battery units 111, 113, and 115 after the discharging period S3. For example, the identifying unit 143 may extract, as the idle period S2 after charging, a period in which the current value of the battery unit 111, 113, or 115 is in a second current range (e.g., a range of -1 A to 0 A).

In an embodiment, the identifying unit 143 may identify the second voltage values of each of the plurality of battery units 111, 113, and 115 in the extracted different idle periods (e.g., idle periods after different charging or idle periods after different discharging).

In an embodiment, the determining unit 145 may determine average voltage values of different idle periods (e.g., idle periods after different charging or idle periods after different discharging) of each of the plurality of battery units 111, 113, and 115, based on the second voltage values. For example, the determining unit 145 may determine the average voltage values of the idle periods after different charging for each of the plurality of battery units 111, 113, and 115, as shown in Table 1 below.

**[Table 1]**

| Idle Period | Battery Unit | | | |
|---|---|---|---|---|
| | 111 | 113 | ... | 115 |
| Idle Period after First Charging | 4.0514 | 4.0502 | ... | 4.0531 |
| Idle Period after Second Charging | 4.0513 | 4.0495 | ... | 4.0531 |
| Idle Period after Third Charging | 4.0513 | 4.0485 | ... | 4.0530 |
| Idle Period after Fourth Charging | 4.0513 | 4.0460 | ... | 4.0530 |

Referring to [Table 1], an average voltage of the battery unit 111 is maintained constant such as 4.0514, 4.0513, 4.0513, and 4.0513 even when idle periods after charging continue, whereas an average voltage of the battery 113 relatively drops such as 4.0502, 4.0495, 4.0485, and 4.0460 even when the idle periods after charging continue.

In another example, the determining unit 145 may determine the average voltage values of the idle periods after different discharging for each of the plurality of battery units 111, 113, and 115, as shown in Table 2 below.

**[Table 2]**

| Idle Period | Battery Unit | | | |
|---|---|---|---|---|
| | 111 | 113 | ... | 115 |
| Idle Period after First Discharging | 3.5122 | 3.5125 | ... | 3.5122 |
| Idle Period after Second Discharging | 3.5122 | 3.5102 | ... | 3.5122 |
| Idle Period after Third Discharging | 3.5122 | 3.5088 | ... | 3.5122 |
| Idle Period after Fourth Discharging | 3.5122 | 3.5049 | ... | 3.5122 |

Referring to [Table 2], an average voltage of the battery unit 111 is maintained constant such as 3.5122, 3.5122, 3.5122, and 3.5122 even when idle periods after discharging continue, whereas an average voltage of the battery 113 relatively drops such as 3.5125, 3.5102, 3.5088, and 3.5049 even when the idle periods after discharging continue.

In an embodiment, the diagnosing unit 147 may diagnose the abnormality of each of the plurality of battery units 111, 113, and 115, based on at least one deviation value among the average voltage values. Herein, the at least one deviation value may be a result of subtracting, from an average voltage value of a preceding idle period, an average voltage value of a specific idle period after the preceding idle period.

In an embodiment, the diagnosing unit 147 may calculate, for each of the plurality of battery units 111, 113, and 115, a first deviation value that is a result of subtracting, from a second average voltage value of a second idle period after a first idle period, a first average voltage value of the first idle period, among the average voltage values. The diagnosing unit 147 may diagnose the abnormality of the battery unit 111, 113, or 115 based on the calculated first deviation value. In an embodiment, the diagnosing unit 147 may diagnose, as an abnormal battery unit, the battery unit 111, 113, or 115 having the calculated first deviation value greater than a designated value.

For example, the diagnosing unit 147 may calculate a deviation value of 0.0007 that is a result of subtracting an average voltage value of 4.0495 in an idle period after second charging from an average voltage value of 4.0502 in an idle period after first charging in the battery unit 113 of [Table 1]. As the calculated deviation value of 0.0007 is greater than a designated value (e.g., 0), the diagnosing unit 147 may diagnose the battery unit 113 as an abnormal battery unit.

In an embodiment, the diagnosing unit 147 may diagnose the abnormality of each of the plurality of battery units 111, 113, and 115, based on at least one of a maximum value, a minimum value, or an average value of at least one deviation value among the average voltage values. In an embodiment, the diagnosing unit 147 may diagnose the abnormality of each of the plurality of battery units 111, 113, and 115, based on at least one of a maximum value, a minimum value, or an average value of at least three deviation values among the average voltage values of the battery unit 111, 113, or 115.

Hereinbelow, by using the battery unit 113 of Table 1 as an example, a description will be made of a method, performed by the diagnosing unit 147, of diagnosing an abnormality of the battery unit 113 based on at least one of a maximum value, a minimum value, or an average value of at least one deviation value.

The diagnosing unit 147 may calculate the first deviation value of 0.0007 that is a result of subtracting an average voltage value of 4.0495 in an idle period after second charging from an average voltage value of 4.0502 in an idle period after first charging in the battery unit 113 of [Table 1]. The diagnosing unit 147 may calculate a second deviation value of 0.001 that is a result of subtracting an average voltage value of 4.0485 in an idle period after third charging from an average voltage value of 4.0495 in an idle period after second charging in the battery unit 113. The diagnosing unit 147 may calculate a third deviation value of 0.0025 that is a result of subtracting an average voltage value of 4.0460 in an idle period after fourth charging from an average voltage value of 4.0485 in an idle period after third charging in the battery unit 113. The diagnosing unit 147 may diagnose the abnormality of the battery unit 113, based on at least one of a maximum value, a minimum value, or an average value of the first deviation value, the second deviation value, and the third deviation value. For example, as a maximum value of 0.0025 among the deviation values is greater than a first reference value (e.g., 0.002), the diagnosing unit 147 may diagnose the battery unit 113 as an abnormal battery unit. In another example, as a minimum value of 0.0007 among the deviation values is greater than a second reference value (e.g., 0), the diagnosing unit 147 may diagnose the battery unit 113 as an abnormal battery unit. In another example, as an average value of 0.0014 among the deviation values is greater than a third reference value (e.g., 0.001), the diagnosing unit 147 may diagnose the battery unit 113 as an abnormal battery unit.

The diagnosing unit 147 may diagnose, as an abnormal battery unit, the battery unit 111, 113, or 115 having an average voltage value relatively dropping as the idle period continues, by using the above-described method.

In an embodiment, the abnormality processing unit 149 may perform an abnormality processing function based on abnormality diagnosis results for the plurality of battery units 111, 113, and 115. In an embodiment, the abnormality processing function may include a notification function or a shortcircuit function.

For example, the abnormality processing unit 149 may transmit the abnormality diagnosis results of the plurality of battery units 111, 113, and 115 to the user terminal 105 connected through a wired and/or wireless network.

In another embodiment, the abnormality processing unit 149 may isolate the abnormality battery unit from the electronic device 103 based on the abnormality diagnosis results of the plurality of battery units 111, 113, and 115. Herein, isolation may include electrical and/or mechanical isolation.

FIG. 4 is an operating flowchart of a battery diagnosis apparatus according to an embodiment. FIG. 4 will be described using components of FIG. 2.

The embodiment shown in FIG. 4 may be an example, and an order of operations according to various embodiments of the present disclosure may be different from that shown in FIG. 4, and some operations shown in FIG. 4 may be omitted, the order of the operations may be changed, or the operations may be merged.

Referring to FIG. 4, in operation 405, the battery diagnosis apparatus 101 may obtain the first voltage values of each of the plurality of battery units 111, 113, and 115. In an embodiment, the battery diagnosis apparatus 101 may obtain a plurality of voltage profiles respectively indicating voltage changes of the plurality of battery units 111, 113, and 115 over time. The battery diagnosis apparatus 101 may obtain the first voltage values based on the obtained plurality of voltage profiles.

In an embodiment, the battery diagnosis apparatus 101 may obtain the first voltage values of each of the plurality of battery unit 111, 113, and 115 through the electronic device 103 connected through a wired and/or wireless network.

In operation 410, the battery diagnosis apparatus 101 may identify the second voltage values in different idle periods from among the first voltage values obtained in operation 505. In an embodiment, the battery diagnosis apparatus 101 may set the different idle periods as periods having voltage values, current values, the amounts of charge, and/or the amounts of discharge in designated ranges. The battery diagnosis apparatus 101 may extract the different idle periods for each of the plurality of battery units 111, 113, and 115 from the obtained plurality of voltage profiles, and identify the second voltage values in the corresponding periods for each of the plurality of battery units 111, 113, and 115.

In an embodiment, the different idle periods may be idle periods after different charging or idle periods after different discharging.

In operation 415, the battery diagnosis apparatus 101 may determine average voltage values of different idle periods (e.g., idle periods after different charging or idle periods after different discharging) of each of the plurality of battery units 111, 113, and 115, based on the second voltage values identified in operation 410.

In operation 420, the battery diagnosis apparatus 101 may diagnose an abnormality of each of the plurality of battery units 111, 113, and 115.

In an embodiment, the battery diagnosis apparatus 101 may diagnose the abnormality of each of the plurality of battery units 111, 113, and 115, based on at least one deviation value among the average voltage values determined in operation 415. Herein, the at least one deviation value may be a result of subtracting, from an average voltage value of a preceding idle period, an average voltage value of a specific idle period after the preceding idle period.

In an embodiment, the battery diagnosis apparatus 101 may calculate, for each of the plurality of battery units 111, 113, and 115, a first deviation value that is a result of subtracting, from a second average voltage value of a second idle period after a first idle period, a first average voltage value of the first idle period, among the average voltage values. The battery diagnosis apparatus 101 may diagnose the abnormality of the battery unit 111, 113, or 115 based on the calculated first deviation value. In an embodiment, the diagnosing unit 147 may diagnose, as an abnormal battery unit, the battery unit 111, 113, or 115 having the calculated first deviation value greater than a designated value.

In an embodiment, the battery diagnosis apparatus 101 may diagnose the abnormality of each of the plurality of battery units 111, 113, and 115, based on at least one of a maximum value, a minimum value, or an average value of at least one deviation value among the average voltage values. In an embodiment, the battery diagnosis apparatus 101 may diagnose the abnormality of each of the plurality of battery units 111, 113, and 115, based on at least one of a maximum value, a minimum value, or an average value of at least three deviation values among the average voltage values of the battery unit 111, 113, or 115.

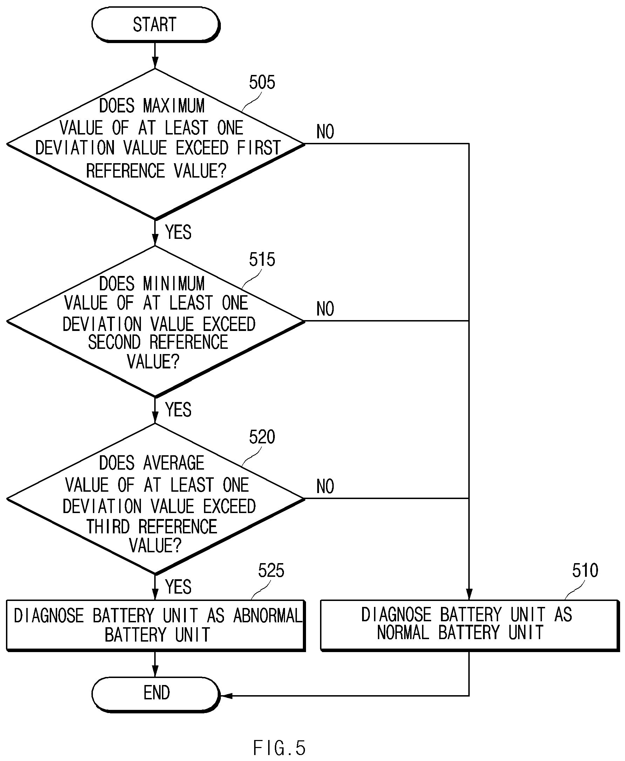

A more detailed description will be made of operation 420 of diagnosing the abnormality of each of the plurality of battery units 111, 113, and 115 by the battery diagnosis apparatus with reference to FIG. 5

FIG. 5 is an operating flowchart of a battery diagnosis apparatus according to an embodiment. FIG. 5 will be described using components of FIG. 2.

The embodiment shown in FIG. 5 may be an example, and an order of operations according to various embodiments of the present disclosure may be different from that shown in FIG. 5, and some operations shown in FIG. 5 may be omitted, the order of the operations may be changed, or the operations may be merged. For example, in FIG. 5, an operation other than at least one of operation 505, 515, or 520 may be omitted.

In operation 505, the battery diagnosis apparatus 101 may identify whether the maximum value of at least one deviation value of the battery unit 111, 113, or 115 exceeds the first reference value.

When the maximum value of the at least one deviation value of the battery unit 111, 113, or 115 is identified as being less than or equal to the first reference value in operation 505 ('NO'), the battery diagnosis apparatus 101 may diagnose the battery unit 111, 113, or 115 as a normal battery unit in operation 510.

When the maximum value of the at least one deviation value of the battery unit 111, 113, or 115 is identified as exceeding the first reference value in operation 505 ('YES'), the battery diagnosis apparatus 101 may identify whether the maximum value of the at least one deviation value of the battery unit 111, 113, or 115 exceeds a second reference value in operation 515.

When the maximum value of the at least one deviation value of the battery unit 111, 113, or 115 is identified as being less than or equal to the second reference value in operation 515 ('NO'), the battery diagnosis apparatus 101 may diagnose the battery unit 111, 113, or 115 as a normal battery unit in operation 510.

When the maximum value of the at least one deviation value of the battery unit 111, 113, or 115 is identified as exceeding the second reference value in operation 515 ('YES'), the battery diagnosis apparatus 101 may identify whether the average value of the at least one deviation value of the battery unit 111, 113, or 115 exceeds a third reference value in operation 520.

When the average value of the at least one deviation value of the battery unit 111, 113, or 115 is identified as being less than or equal to the third reference value in operation 520 ('NO'), the battery diagnosis apparatus 101 may diagnose the battery unit 111, 113, or 115 as a normal battery unit in operation 510.

When the average value of the at least one deviation value of the battery unit 111, 113, or 115 is identified as exceeding the third reference value in operation 520 ('YES'), the battery diagnosis apparatus 101 may diagnose the battery unit 111, 113, or 115 as an abnormal battery unit in operation 525.

Terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in the present document.

## Claims

1. A battery diagnosis apparatus comprising:
an obtaining unit configured to obtain first voltage values of each of a plurality of battery units;
an identifying unit configured to identify second voltage values in different idle periods from among the first voltage values;
a determining unit configured to determine average voltage values of the different idle periods of each of the plurality of battery units, based on the second voltage values; and
a diagnosing unit configured to diagnose an abnormality of each of the plurality of battery units, based on at least one deviation value among the average voltage values.

2. The battery diagnosis apparatus of claim 1, wherein the diagnosing unit is further configured to:
calculate, for each of the plurality of battery units, a first deviation value that is a result of subtracting, from a second average voltage value of a second idle period after a first idle period, a first average voltage value of the first idle period, among the average voltage values; and
diagnose an abnormality of each of the plurality of battery units, based on the first deviation value.

3. The battery diagnosis apparatus of claim 1, wherein the diagnosing unit is further configured to diagnose an abnormality of each of the plurality of battery units, based on at least one of a maximum value, a minimum value, or an average value of the at least one deviation value.

4. The battery diagnosis apparatus of claim 3, wherein the diagnosing unit is further configured to diagnose at least one battery unit having the maximum value greater than a first reference value, as an abnormal battery unit.

5. The battery diagnosis apparatus of claim 3, wherein the diagnosing unit is further configured to diagnose at least one battery unit having the minimum value greater than a second reference value, as an abnormal battery unit.

6. The battery diagnosis apparatus of claim 3, wherein the diagnosing unit is further configured to diagnose at least one battery unit having the average value greater than a third reference value, as an abnormal battery unit.

7. The battery diagnosis apparatus of claim 1, wherein the identifying unit is further configured to set the different idle periods as periods having voltage values, current values, the amounts of charge, and/or the amounts of discharge in designated ranges.

8. The battery diagnosis apparatus of claim 1, wherein an abnormality processing unit configured to perform an abnormality processing function based on an abnormality diagnosis result of each of the plurality of battery units,
wherein the abnormality processing function comprises a notification function or a shortcircuit function.

9. A battery diagnosis method comprising:
obtaining first voltage values of each of a plurality of battery units;
identifying second voltage values in different idle periods from among the first voltage values;
determining average voltage values of the different idle periods of each of the plurality of battery units, based on the second voltage values; and
diagnosing an abnormality of each of the plurality of battery units, based on at least one deviation value among the average voltage values.

10. The battery diagnosis method of claim 9, wherein the diagnosing of the abnormality of each of the plurality of battery units comprises:
calculating, for each of the plurality of battery units, a first deviation value that is a result of subtracting, from a second average voltage value of a second idle period after a first idle period, a first average voltage value of the first idle period, among the average voltage values; and
diagnosing an abnormality of each of the plurality of battery units, based on the first deviation value.

11. The battery diagnosis method of claim 9, wherein the diagnosing of the abnormality of each of the plurality of battery units comprises diagnosing the abnormality of each of the plurality of battery units, based on at least one of a maximum value, a minimum value, or an average value of the at least one deviation value.

12. The battery diagnosis method of claim 11, wherein the diagnosing of the abnormality of each of the plurality of battery units comprises diagnosing at least one battery unit having the maximum value greater than a first reference value, as an abnormal battery unit.

13. The battery diagnosis method of claim 11, wherein the diagnosing of the abnormality of each of the plurality of battery units comprises diagnosing at least one battery unit having the minimum value greater than a second reference value, as an abnormal battery unit.

14. The battery diagnosis method of claim 11, wherein the diagnosing of the abnormality of each of the plurality of battery units comprises diagnosing at least one battery unit having the average value greater than a third reference value, as an abnormal battery unit.

15. The battery diagnosis method of claim 9, further comprising setting the different idle periods as periods having voltage values, current values, amounts of charge, and/or amounts of discharge in designated ranges.
